# EUROPÄISCHE PATENTSCHRIFT

(11) **EP 1 614 125 B1**
(45) Veröffentlichungstag und Bekanntmachung des Hinweises auf die Patenterteilung: **13.06.2007**
(21) Anmeldenummer: 04727220.8
(22) Anmeldetag: 14.04.2004
(51) Int. Cl.: H01C 1/144, H01C 17/28, H01G 13/00, H01L 21/48, H01L 23/485, H01L 23/498

(54) **Verfahren zur Erzeugung von Lotkugeln auf einem elektrischen Bauelement**
Method for producing soldering globules on an electrical component
Procédé de production de globules de brasage sur un composant électrique

(30) Priorität: 16.04.2003 DE 10317596
(43) Veröffentlichungstag der Anmeldung: 11.01.2006
(73) Patentinhaber: EPCOS AG, 81669 München (DE)
(72) Erfinder: FEICHTINGER, Thomas, A-8010 Graz (AT); PUDMICH, Günther, A-8580 Köflach (AT)
(74) Vertreter: Epping, Wilhelm
(86) Internationale Anmeldenummer: PCT/DE2004/000769
(87) Internationale Veröffentlichungsnummer: WO 2004/093100

(56) Entgegenhaltungen:
- EP-A- 1 239 514
- US-B1- 6 380 061

## Beschreibung

Bei Halbleiterbauelementen werden häufig Lotkugeln (Bumps) für das Montieren der Bauelemente auf Substrate eingesetzt. Dabei werden die Bauelemente in der Regel in Flip-Chip-Bauweise mittels Lotkugeln auf dem Substrat montiert, wobei auf dem Substrat häufig Kontaktflächen zur elektrisch leitenden Kontaktierung der Lotkugeln vorhanden sind. Ein solches Halbleiterbauelement mit dem korrespondierendem Herstellungsverfahren ist in dem Dokument US-B-6 380 061 beschrieben. Bei den Halbleiterbauelementen ist häufig die oberste Metallschicht, die im Kontakt mit den Lotkugeln steht, Aluminium oder ein verwandtes Metall. Aufgrund einer auf dem Aluminium vorhandenen elektrisch isolierenden Aluminiumoxidschicht und aufgrund der nicht benetzenden Eigenschaften des Aluminiums für Lote müssen zwischen der Lotkugel und der Metallschicht des Halbleiterbauelements häufig verschiedene weitere Metallschichten angeordnet werden. Diese sorgen beispielsweise für eine gute Adhäsion der Lotkugeln und können mit dem Material der Lotkugeln benetzt werden. Diese sogenannte "Under bump metallization" (UBM) wird dabei häufig mittels aufwendiger galvanischer oder anderer Verfahren auf dem Halbleiterchip aufgebracht. Die Erzeugung der Under-bump-Metallisierung verursacht dabei einen hohen Arbeits- und damit Kostenaufwand.

Aufgabe des vorliegenden erfindungsgemäßen Verfahrens ist es, ein Verfahren zur Erzeugung von elektrischen Kontaktierungen in Form von Lotkugeln anzugeben, bei dem die oben genannte Under-bump-Metallisierung nicht benötigt wird und gleichzeitig auf besonders einfache Weise die Lotkugeln auf einem elektrischen Bauelement erzeugt werden können.

Diese Aufgabe wird erfindungsgemäß durch ein Verfahren nach Anspruch 1 gelöst. Vorteilhafte Ausgestaltungen des Verfahrens sind Gegenstand von Unteransprüchen.

Die Erfindung beschreibt ein Verfahren zur Erzeugung von elektrischen Kontaktierungen in Form von Lotkugeln auf einem elektrischen Bauelement, das einen Grundkörper umfaßt, wobei folgende Verfahrensschritte durchgeführt werden: Im Verfahrensschritt A) wird auf einem Grundkörper des elektrischen Bauelements eine Schablone angeordnet. Anschließend werden im Verfahrensschritt B) durch die Schablone hindurch Durchbohrungen erzeugt. Danach werden durch Befüllung der Durchbohrung mit einem elektrisch leitfähigen Material auf ein höheres Niveau als die Oberfläche des Grundkörpers Füllungen erzeugt (Verfahrensschritt C). Im Verfahrensschritt D) werden die Füllungen dann ausgehärtet, wobei diese aus dem Grundkörper des elektrischen Bauelements hervorstehen. Im Verfahrensschritt E) werden Lotkugeln zur externen elektrischen Kontaktierung der Füllungen direkt auf den Oberflächen der Füllungen erzeugt.

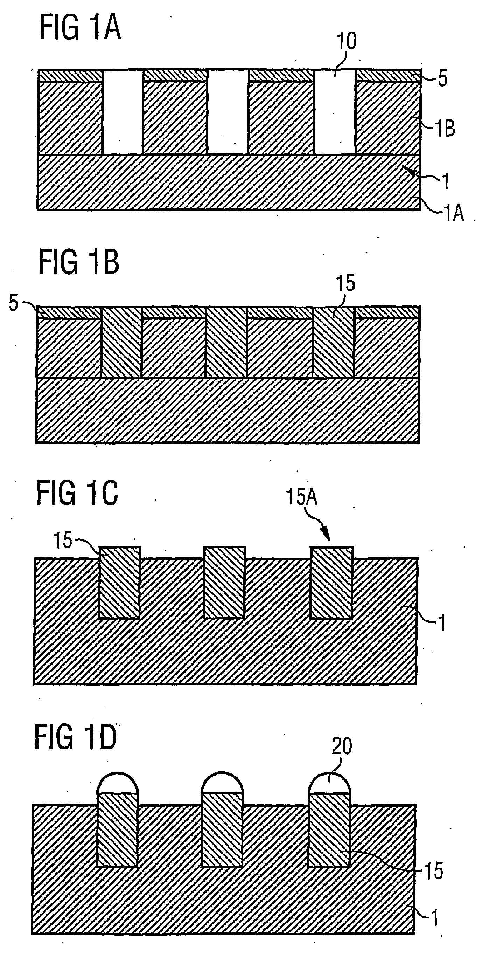

Das erfindungsgemäße Verfahren gibt ein besonders einfaches Verfahren an, um im Inneren des Bauelements befindliche Bereiche mittels der Lotkugeln extern elektrisch leitend zu kontaktieren. Die auf dem Grundkörper angeordnete Schablone dient dabei dazu, den Grundkörper während der Erzeugung der Durchbohrungen mechanisch zu stabilisieren, so daß es zu keinen Bruchstellen im Grundkörper kommt. Gleichzeitig ermöglicht es die Schablone, im Verfahrensschritt C) des erfindungsgemäßen Verfahrens das elektrisch leitfähige Material über die Oberfläche des Grundkörper hinaus in die Durchbohrungen einzufüllen, so daß dann im Verfahrensschritt D) bei der Aushärtung die Füllungen über den Grundkörper des elektrischen Bauelements hervorstehen können. Auf diesen hervorstehenden Oberflächen der Füllungen können dann besonders einfach die Lotkugeln direkt erzeugt werden (siehe beispielsweise Figuren 1A bis 1D). Dabei sind keine Under-bump-Metallisierungen zwischen den Füllungen und den Lotkugeln notwendig. In einer vorteilhaften Variante des erfindungsgemäßen Verfahrens wird im Verfahrensschritt A) eine Schablone mit Öffnungen verwendet und anschließend im Verfahrensschritt B) die Durchbohrungen durch die Öffnungen hindurch erzeugt.

Dabei dient die Schablone als Matrize zur Erzeugung der Durchbohrungen und gibt dabei die Position der Durchbohrungen im Grundkörper an, so daß eine besonders einfache Erzeugung der Durchbohrungen möglich ist.

Weiterhin ist es möglich, daß ein keramischer Grünkörper für das elektrische Bauelement verwendet wird, wobei dieser dann vorteilhafterweise im Verfahrensschritt D) zusammen mit den Füllungen gesintert wird. Die Sinterung des Grünkörpers kann dabei bei 1000°C bis 1200°C erfolgen. Somit werden besonders vorteilhaft in einem Verfahrensschritt der Grünkörper gesintert und gleichzeitig die Füllungen ausgehärtet.

In einer weiteren günstigen Ausführungsform des erfindungsgemäßen Verfahrens wird eine Schablone verwendet, die ein Polymermaterial umfaßt. Dieses kann beispielsweise ein Kunststoff, zum Beispiel Polyphenylensulfid (PPS) oder Polyethylentherephtalat (PET) sein. Die Schablone ist vorteilhafterweise eine organische Folie hoher Steifheit, die den Grundkörper mechanisch stabilisiert und dabei günstigerweise stanzbar ist. Die Schablone wird besonders vorteilhaft während der Aushärtung der Füllungen im Verfahrensschritt D) und einer eventuell stattfindenden Sinterung des keramischen Grünkörpers verdampft, so daß sie sich während dieses Verfahrensschrittes auflöst. Dabei kann die Schablone zu Beginn des Aushärtungsschrittes nach wie vor die noch nicht ausgehärteten Füllungen in den Durchbohrungen halten, wird dann aber allerdings mittels Verdampfung entfernt, so daß ein anschließendes Abziehen der Folie nicht mehr erforderlich ist. Unter Verdampfen im Sinne der Erfindung wird auch Entkohlung verstanden.

Im Verfahrensschritt B) können die Durchbohrungen vorteilhafterweise mittels Stanzen erzeugt werden. Stanzen ermöglicht eine besonders einfache und kostengünstige Erzeugung der Durchbohrungen.

Weiterhin ist es möglich, daß vor dem Verfahrensschritt A) mehrere mit Abstand im Grundkörper angeordnete Elektrodenflächen erzeugt werden, die Elektroden enthalten. Zwischen den Elektroden befinden sich dann jeweils Bereiche des Grundkörpers. Dann können die Füllungen so erzeugt werden, daß sie elektrisch leitend mit den Elektroden verbunden sind. Der Vorteil besteht darin, daß die Füllungen dann als elektrisch leitende Durchkontaktierungen dienen, die die Elektroden elektrisch leitend mit den Lotkugeln auf der Oberfläche des Bauelements verbinden. Diese Elektroden ermöglichen es, den Widerstand, die Kapazität und auch andere elektrische Eigenschaften des Bauelements beliebig zu variieren.

Möglich ist es auch, in einer weiteren Ausführungsform des Verfahrens den Grundkörper durch Übereinanderstapeln von keramischen Grünfolien zu bilden. Dabei können die Elektroden auf einzelnen keramischen Grünfolien erzeugt werden. Dies ist besonders einfach mittels Druckverfahren, zum Beispiel dem Siebdruckverfahren möglich. Möglich ist es jedoch auch, zunächst die Durchbohrungen in einer einzelnen keramischen Grünfolie zu erzeugen, bevor der Grundkörper mit dieser Grünfolie als oberster Schicht durch das Übereinanderstapeln erzeugt wird.

In einem Verfahrensschritt D1) zwischen den Verfahrenschritten D) und E) können die überstehenden Oberflächen der Füllungen mechanisch und/oder chemisch behandelt werden. Diese Behandlung kann besonders vorteilhaft dazu dienen, eine bessere Benetzbarkeit der Oberflächen der Füllungen für die Lotkügeln zu erreichen. Eine mechanische Behandlung kann beispielsweise mittels Läppen und Sandstrahlen erfolgen. Chemische Behandlung kann durch Säuren und Laugen erfolgen.

Günstigerweise werden im Verfahrensschritt C) Metallpasten als elektrisch leitfähiges Material verwendet, die Pd, Pt, AgPd, AgPt und AgPdPt als Metalle und Metallegierungen umfassen. Diese Metalle und Metallegierungen ermöglichen eine besonders gute Benetzbarkeit und Haftung der Lotkugeln auf den elektrisch leitenden Füllungen.

Im Verfahrensschritt E) können die Lotkugeln beispielsweise mittels eines galvanischen Verfahrens erzeugt werden. Möglich ist es auch im Verfahrensschritt E) Lotkugeln besonders einfach durch in Kontaktbringen der Oberflächen der Füllungen mit einem Lotbad zu erzeugen.

Im Verfahrensschritt E) können günstigerweise folgende Metalle und Metallegierungen für die Lotkugeln verwendet werden: Sn, SnPb, SnAgCu, SnAgCuBi, SnZn und SnAg. Die Metalle beziehungsweise Metallegierungen eignen sich besonders gut dafür, mittels eines Lotverfahrens auf die Füllungen aufgebracht zu werden.

Weiterhin kann im erfindungsgemäßen Verfahren ein Grundkörper verwendet werden, der ein keramisches Material umfaßt das beispielsweise eine Varistorkeramik auf Basis von ZnO-Bi oder ZnO-Pr darstellt. Ein derartiges, mittels des erfindungsgemäßen Verfahrens hergestelltes elektrisches Bauelement wäre dann ein Varistor, der als spannungsabhängiger Widerstand beispielsweise zur Überspannungssicherung von Schaltkreisen verwendet werden kann. Das keramische Material des Grundkörpers kann weiterhin eine Kondensatorkeramik umfassen, die ausgewählt ist aus sogenannten NP0-Keramiken zum Beispiel (Sm, Pa) NiCdO₃. Diese Keramiken weisen temperaturabhängige ε_{R}-Werte auf und sind nicht ferroelektrische Keramiken. Weiterhin können auch ferroelektrische Keramiken mit hohen Dielektrizitätskonstanten, sowie dotiertes Bariumtitanat und sogenannte Sperrschichtkeramiken verwendet werden. All diese dielektrischen Keramiken werden im Buch "Keramik" von H. Schaumburg (Herausgeber, B. G. Teubner Verlag Stuttgart, 1994) auf den Seiten 351 bis 352 und 363 beschrieben, wobei auf diese Seiten hiermit vollinhaltlich Bezug genommen wird. Darüber hinaus kann das keramische Material aus Thermistorkeramiken, z.B. NTC-Keramiken, beispielsweise Nickel-Mangan-Spinellen und Perowskiten ausgewählt sein. Weiterhin können auf Ferrite, sowie dielektrische, nicht keramische Materialien zum Beispiel Gläser als Materialien für den Grundkörper im erfindungsgemäßen Verfahren verwendet werden.

Im folgenden soll das erfindungsgemäße Verfahren anhand von schematischen Figuren und Ausführungsbeispielen noch näher erläutert werden.

Die Figuren 1A bis 1D zeigen eine Variante eines erfindungsgemäßen Verfahrens an Hand schematischer Querschnitte.

Die Figur 2 zeigt einen Querschnitt durch ein Bauelement, das mittels eines erfindungsgemäßen Verfahrens hergestellt wurde.

Die Figur 1A zeigt den Grundkörper 1 eines elektrischen Bauelements nach dem Verfahrensschritt B), Auf dem keramischen Grundkörper ist eine Schablone 5 angeordnet worden, wobei beispielsweise mittels Stanzen durch die Schablone 5 hindurch die Durchbohrungen 10 erzeugt worden sind. Wobei in der Schablone 5 und im Grundkörper 10 gemeinsam die Durchbohrungen z.B. mittels Stanzens erzeugt werden können. Der Grundkörper 1 kann dabei verschiedene keramische Teilbereiche 1A und 1B, beispielsweise verschiedene keramische Grünfolien umfassen. Im Falle eines Varistorbauelements kann der Grundkörper dabei ZnO-Bi umfassen. Die Schablone kann dabei aus organischen Polymeren geeigneter Steifheit, beispielsweise aus der Klasse der Polyphenylensulfide (PPS) oder Polyethylentherephtalate (PET) bestehen. Zur Sicherstellung einer guten Haftfestigkeit der Schablone auf dem keramischen Grundkörper können auf der Schablone beispielsweise noch Beschichtungen auf der Basis von Silikonen aufgebracht sein.

Figur 1B zeigt einen Querschnitt durch ein Bauelement nach dem Verfahrensschritt C) des erfindungsgemäßen Verfahrens. Dabei wurde in die Durchbohrungen 10 ein elektrisch leitfähiges Material derart eingefüllt, daß die Oberfläche der Füllungen 15 auf einem höheren Niveau in den Durchbohrungen angeordnet wird, als die Oberfläche des Grundkörpers. In diesem Falle ist beispielsweise die Schablone 5 dazu geeignet, oberhalb der Oberfläche des keramischen Grundkörpers befindliches elektrisch leitfähiges Material zurückzuhalten, so daß besonders einfach das Material bis über die Oberfläche des Grundköpers hinaus in die Durchbohrungen 10 eingefüllt werden kann. Als elektrisch leitfähiges Material können dabei beispielsweise Metallpasten der Zusammensetzungen Ag90Pd10, Ag80Pd20, Ag70Pd30 und Ag60Pd40 in Abhängigkeit von der notwendigen Sintertemperatur (jeweilige Anteile im Gewichtsprozent) verwendet werden.

Figur 1C zeigt einen Querschnitt durch einen Grundkörper eines elektrischen Bauelements nach dem Verfahrensschritt D) des erfindungsgemäßen Verfahrens. Im Verfahrensschritt D) wurde dabei beispielsweise bei Temperaturen zwischen 1000°C und 1200°C für zwei bis acht Stunden der keramische Grünkörper gesintert. Dabei wurde ebenfalls das elektrisch leitfähige Material in den Durchbohrungen 10, die bereits oben genannte Metallpaste, gehärtet bzw. mitgesintert. Die Schablone 5, die aus organischen Polymeren besteht wurde bei diesen Temperaturen mittels Verkohlung verdampft. Dabei verbleiben über die.Oberfläche des Grundkörper hervorstehende Bereiche der Füllungen 15. Diese überstehenden Bereiche lassen sich besonders einfach mit Lot benetzen, so daß die Lotkugeln besonders einfach auf den Oberflächen 15A der Füllungen erzeugt werden können.

Figur 1D zeigt einen Querschnitt durch den Grundkörper eines Bauelements nach dem Verfahrensschritt E) eines erfindungsgemäßen Verfahrens. Dazu wurden beispielsweise mittels eines Lotbades, das eine Temperatur von 215°C bis 260°C aufweist, für vier bis zwanzig Sekunden die Lotkugeln auf die Oberflächen 15A der Füllungen 15 erzeugt. Die Lotkugeln können dabei beispielsweise aus Sn60Pb40 bestehen.

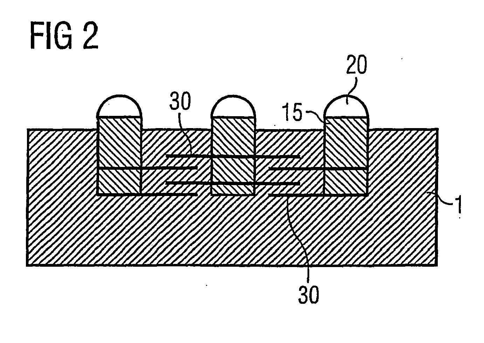

Figur 2 zeigt ein elektrisches Bauelement.mit Elektroden 30 im Querschnitt, dessen elektrische Kontaktierungen mittels des erfindungsgemäßen Verfahrens erzeugt wurden. Dabei dienen die Füllungen 15 als elektrische Durchkontaktierungen, die Innenelektroden 30 mit den auf der Oberfläche des Bauelements angeordneten Lotkugeln 20 elektrisch leitend verbinden.

## Patentansprüche

1. Verfahren zur Erzeugung von elektrischen Kontaktierungen in Form von Lotkugeln (20) auf einem elektrischen Bauelement das einem Grundkörper (1) umfaßt, mit den aufeinanderfolgenden Verfahrensschritten:
A) auf dem Grundkörper (1) des elektrischen Bauelements wird eine Schablone (5) angeordnet,
B) im Grundkörper (1) werden durch die Schablone (5) hindurch Durchbohrungen (10) erzeugt,
C) durch Befüllen der Durchbohrungen mit einem elektrisch leitfähigen Material auf ein höheres Niveau als die Oberfläche des Grundkörpers werden Füllungen (15) erzeugt,
D) die Füllungen (15) werden ausgehärtet, wobei sie aus dem Grundkörper (1) des elektrischen Bauelements hervorstehen,
E) Lotkugeln (20) zur externen elektrischen Kontaktierung der Füllungen (15) werden direkt auf den Oberflächen (15A) der Füllungen erzeugt.

2. Verfahren nach dem vorhergehenden Anspruch,
- bei dem im Verfahrensschritt A) eine Schablone mit Öffnungen verwendet wird,
- bei dem im Verfahrensschritt B) die Durchbohrungen durch die Öffnungen hindurch erzeugt werden.

3. Verfahren nach einem der vorhergehenden Ansprüche,
- bei dem ein keramischer Grünkörper für das elektrische Bauelement verwendet wird,
- bei dem im Verfahrensschritt D) gleichzeitig der keramische Grünkörper gesintert wird.

4. Verfahren nach dem vorhergehenden Anspruch,
- bei dem im Verfahrensschritt D) der Grünkörper bei 1000°C bis 1200°C gesintert wird.

5. Verfahren nach einem der vorhergehenden Ansprüche,
- bei dem eine Schablone verwendet wird, die ein PolymerMaterial umfaßt.

6. Verfahren nach einem der vorhergehenden Ansprüche,
- bei dem im Verfahrensschritt B) die Durchbohrungen mittels Stanzen erzeugt werden.

7. Verfahren nach einem der vorhergehenden Ansprüche,
- bei dem vor dem Verfahrensschritt A) mehrere mit Abstand im Grundkörper angeordnete Elektrodenflächen erzeugt werden, die Elektroden (30) enthalten,
- bei dem die Füllungen so erzeugt werden, daß sie elektrisch leitend mit den Elektroden verbunden sind.

8. Verfahren nach dem vorhergehenden Anspruch,
- bei dem der Grundkörper durch Übereinanderstapeln von keramischen Grünfolien gebildet wird,
- bei dem die Elektroden auf einzelnen keramischen Grünfolien erzeugt werden.

9. Verfahren nach dem vorhergehenden Anspruch,
- bei dem die Elektroden mittels Drucken erzeugt werden.

10. Verfahren nach einem der vorhergehenden Ansprüche,
- bei dem in einem Verfahrensschritt D1) zwischen den Verfahrensschritten D) und E) die Oberflächen der Füllungen mechanisch und/oder chemisch behandelt werden.

11. Verfahren nach dem vorhergehenden Anspruch,
- bei dem die Oberflächen der Füllungen mit mechanischen Verfahren behandelt werden, die ausgewählt sind aus:
- Läppen und Sandstrahlen.

12. Verfahren nach Anspruch 10,
- bei dem die Oberflächen der Füllungen mit chemischen Verbindungen behandelt werden, die ausgewählt sind aus:
- Säuren und Laugen.

13. Verfahren nach einem der vorhergehenden Ansprüche,
- bei dem im Verfahrensschritt C) Metallpasten als elektrisch leitfähiges Material verwendet werden, das eines der folgenden Metalle und Metallegierungen umfasst:
- Pd, Pt, AgPd, AgPt oder AgPdPt.

14. Verfahren nach einem der-vorhergehenden Ansprüche,
- bei dem im Verfahrensschritt E) die Lotkugeln mittels eines galvanischen Verfahrens erzeugt werden.

15. Verfahren nach einem der Ansprüche 1 bis 13,
- bei dem im Verfahrensschritt E) die Lotkugeln durch Inkontaktbringen der Füllungen mit einem Lotbad erzeugt werden.

16. Verfahren nach einem der vorhergehenden Ansprüche,
- bei dem im Verfahrenschritt E) eines der folgende Metalle und Metallegierungen für die Lotkugeln verwendet werden:
- Sn, SnPb, SnAgCu, SnAgCuBi, SnZn oder SnAg.

17. Verfahren nach einem der vorhergehenden Ansprüche,
- bei dem ein Grundkörper verwendet wird, der ein keramisches Material umfaßt, das aus folgenden Keramiken ausgewählt ist:
- Ferrite, ZnO-Bi, ZnO-Pr, NPO-Keramiken, dotiertes BaTiO₃, Nickel-Mangan-Spinelle und Perowskite.

## Claims

1. Method for producing electrical contacts in the form of solder bumps (20) on an electrical component which comprises a base body (1), having the successive method steps:
A) a template (5) is arranged on the base body (1) of the electrical component,
B) holes (10) in the base body (1) are produced through the template (5),
C) fillings (15) are produced by filling the holes with an electrically conductive material to a level higher than the surface of the base body,
D) the fillings (15) are hardened, so that they protrude from the base body (1) of the electrical component,
E) solder bumps (20) for external electrical contacting of the fillings (15) are produced directly on the surfaces (15A) of the fillings.

2. Method according to the preceding claim,
- wherein a template with openings is used in method step A),
- wherein the holes are produced through the openings in method step B).

3. Method according to one of the preceding claims,
- wherein a ceramic green body is used for the electrical component,
- wherein the ceramic green body is simultaneously sintered in method step D).

4. Method according to the preceding claim,
- wherein the green body is sintered at 1000°C to 1200°C in method step D).

5. Method according to one of the preceding claims,
- wherein a template which comprises a polymer material is used.

6. Method according to one of the preceding claims,
- wherein the holes are produced by means of punching in method step B).

7. Method according to one of the preceding claims,
- wherein a plurality of electrode surfaces arranged with a spacing in the base body, which contain electrodes (30), are produced before method step A),
- wherein the fillings are produced so that they are electrically conductively connected to the electrodes.

8. Method according to the preceding claim,
- wherein the green body is formed by stacking ceramic green sheets,
- wherein the electrodes are produced on individual ceramic green sheets.

9. Method according to the preceding claim,
- wherein the electrodes are produced by means of printing.

10. Method according to one of the preceding claims,
- wherein the surfaces of the fillings are mechanically and/or chemically treated in a method step D1) between method steps D) and E).

11. Method according to the preceding claim,
- wherein the surfaces of the fillings are treated by mechanical methods, which are selected from:
- lapping and sandblasting.

12. Method according to Claim 10,
- wherein the surfaces of the fillings are treated with chemical compounds, which are selected from:
- acids and alkalis.

13. Method according to one of the preceding claims,
- wherein metal pastes are used in method step C) as electrically conductive material, which comprises one of the following metals and metal alloys:
- Pd, Pt, AgPd, AgPt or AgPdPt.

14. Method according to one of the preceding claims,
- wherein the solder bumps are produced by means of an electrolytic method in method step E).

15. Method according to one of Claims 1 to 13,
- wherein the solder bumps are produced in method step E) by bringing the fillings in contact with a solder bath.

16. Method according to one of the preceding claims,
- wherein one of the following metals and metal alloys are used for the solder bumps in method step E):
- Sn, SnPb, SnAgCu, SnAgCuBi, SnZn or SnAg.

17. Method according to one of the preceding claims,
- wherein a base body is used, which comprises a ceramic material which is selected from the following ceramics:
- ferrites, ZnO-Bi, ZnO-Pr, NPO ceramics, doped BaTiO₃, nickel-manganese spinels and perovskites.

## Revendications

1. Procédé de production de contacts électriques sous la forme de billes de soudure (20) sur un composant électrique qui comporte un corps de base (1), ledit procédé comportant les étapes de procédé successives consistant à :
A) placer un gabarit (5) sur le corps de base (1) du composant électrique,
B) produire dans le corps de base (1) des perçages (10) en passant à travers le gabarit (5),
C) remplir les perçages d'un matériau électriquement conducteur jusqu'à ce que les matières de remplissage (15) atteignent un niveau plus élevé que la surface du corps de base,
D) faire durcir les matières de remplissage (15) de façon à ce qu'elles fassent saillie du corps de base (1) du composant électrique,
E) produire des billes de soudure (20) directement sur la surface (15A) des matières de remplissage pour réaliser la mise en contact électrique externe des matières de remplissage (15).

2. Procédé selon la revendication précédente, dans lequel
- à l'étape de procédé A), on utilise un gabarit doté d'ouvertures,
- à l'étape de procédé B), on réalise les perçages en passant par les ouvertures.

3. Procédé selon l'une des revendications précédentes, dans lequel
- on utilise un corps en céramique crue pour le composant électrique,
- à l'étape de procédé D), on fritte simultanément le corps en céramique crue.

4. Procédé selon la revendication précédente, dans lequel
- à l'étape de procédé D), le corps en céramique crue est frittée à une température allant de 1000°C à 1200°C.

5. Procédé selon l'une des revendications précédentes, dans lequel
- on utilise un gabarit qui comporte un matériau polymère.

6. Procédé selon l'une des revendications précédentes, dans lequel
- à l'étape de procédé B), on produit les perçages par estampage.

7. Procédé selon l'une des revendications précédentes, dans lequel
- avant l'étape de procédé A), on produit plusieurs surfaces à électrodes qui sont à distance dans le corps de base et qui contiennent des électrodes (30),
- les matières de remplissage sont produites de façon à être reliées de manière électriquement conductrice aux électrodes.

8. Procédé selon la revendication précédente, dans lequel
- le corps de base est formé par empilage de feuilles en céramique crue,
- les électrodes sont produites sur des feuilles individuelles en céramique crue.

9. Procédé selon la revendication précédente, dans lequel
- les électrodes sont produites par impression.

10. Procédé selon l'une des revendications précédentes, dans lequel
- à une étape de procédé D1) située entre les étapes de procédé D) et E), la surface des matières de remplissage est soumise à un traitement mécanique et/ou chimique.

11. Procédé selon la revendication précédente, dans lequel
- la surface des matières de remplissage est traitée par un procédé mécanique qui est choisi parmi :
- le rodage et le sablage.

12. Procédé selon la revendication 10, dans lequel
- la surface des matières de remplissage est traitée avec des composés chimiques qui sont choisis parmi :
- des acides et des bases.

13. Procédé selon l'une des revendications précédentes, dans lequel
- à l'étape de procédé C), on utilise des pâtes métalliques comme matériau électriquement conducteur qui comporte l'un des métaux et alliages métalliques suivant :
- Pd, Pt, AgPd, AgPt ou AgPdPt.

14. Procédé selon l'une des revendications précédentes, dans lequel
- à l'étape de procédé E), les billes de soudure sont produites par un procédé galvanique.

15. Procédé selon l'une des revendications 1 à 13, dans lequel
- à l'étape de procédé E), les billes de soudure sont produites en mettant en contact les matières de remplissage avec un bain de soudure.

16. Procédé selon l'une des revendications précédentes, dans lequel
- à l'étape de procédé E), on utilise l'un des métaux et alliages métalliques suivants pour les billes de soudure :
- Sn, SnPb, SnAgCu, SnAgCuBi, SnZn ou SnAg.

17. Procédé selon l'une des revendications précédentes, dans lequel
- on utilise un corps de base qui comporte un matériau céramique qui est choisi parmi les céramiques suivantes :
- les ferrites, ZnO-Bi, ZnO-Pr, les céramiques NPO, le BaTiO₃ dopé, les spinelles au nickel-manganèse et les perovskites.
